(19) Europäisches Patentamt / European Patent Office / Office européen des brevets

(11) **EP 3 968 037 B1**

(12) **EUROPÄISCHE PATENTSCHRIFT**

(45) Veröffentlichungstag und Bekanntmachung des Hinweises auf die Patenterteilung:
**03.07.2024 Patentblatt 2024/27**

(21) Anmeldenummer: **20195488.0**

(22) Anmeldetag: **10.09.2020**

(51) Internationale Patentklassifikation (IPC):
***G01R 31/08*** *(2020.01)*

(52) Gemeinsame Patentklassifikation (CPC):
**G01R 31/086; Y04S 10/52**

(54) **VERFAHREN UND EINRICHTUNG ZUM ERMITTELN EINES FEHLERORTES IN EINEM ELEKTRISCHEN ENERGIEVERTEILNETZ**

METHOD AND DEVICE FOR DETECTING A FAULT LOCATION IN AN ELECTRICAL ENERGY DISTRIBUTION NETWORK

PROCÉDÉ ET DISPOSITIF DE DÉTERMINATION D'UN EMPLACEMENT DÉFECTUEUX DANS UN RÉSEAU DE DISTRIBUTION D'ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.03.2022 Patentblatt 2022/11**

(73) Patentinhaber: **Siemens Aktiengesellschaft**
**80333 München (DE)**

(72) Erfinder:
• **Dzienis, Cezary**
  **14624 Dallgow-Döberitz (DE)**
• **Jurisch, Andreas**
  **16727 Schwante (DE)**

(74) Vertreter: **Siemens Patent Attorneys**
**Postfach 22 16 34**
**80506 München (DE)**

(56) Entgegenhaltungen:
**WO-A1-2019/232595     US-A1- 2020 110 124**

• **FLUTY WESLEY ET AL: "Electric Transmission Fault Location Techniques Using Traveling Wave Method and Discrete Wavelet Transform", 2020 CLEMSON UNIVERSITY POWER SYSTEMS CONFERENCE (PSC), IEEE, 10. März 2020 (2020-03-10), Seiten 1-8, XP033787605, DOI: 10.1109/PSC50246.2020.9131271 [gefunden am 2020-07-01]**
• **GUZMAN ARMANDO ET AL: "Accurate and economical traveling-wave fault locating without communications", 2018 71ST ANNUAL CONFERENCE FOR PROTECTIVE RELAY ENGINEERS (CPRE), IEEE, 26. März 2018 (2018-03-26), Seiten 1-18, XP033335997, DOI: 10.1109/CPRE.2018.8349768 [gefunden am 2018-04-25]**

**EP 3 968 037 B1**

**Beschreibung**

Die Erfindung betrifft ein Verfahren zum Ermitteln eines Fehlerortes in einem elektrischen Energieverteilnetz, wobei das Energieverteilnetz zumindest eine Einspeisung sowie Leitungen in Form eines Hauptstrangs und einer Mehrzahl von vom Hauptstrang abgehenden Abzweigen aufweist, und wobei bei dem Verfahren an einer ersten Messstelle des Energieverteilnetzes erste Messwerte erfasst werden, an einer zweiten Messstelle des Energieverteilnetzes zweite Messwerte erfasst werden, und anhand der ersten und der zweiten Messwerte der Fehlerort des im Energieverteilnetz aufgetretenen Fehlers ermittelt wird.

Die Erfindung betrifft auch eine Einrichtung zur Durchführung eines solchen Verfahrens.

Der sichere Betrieb elektrischer Energieversorgungsnetze erfordert eine schnelle und zuverlässige Erkennung und Abschaltung etwaiger Fehler, wie z.B. Kurzschlüsse oder Erdschlüsse. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Der Fehlerort, an dem sich der Fehler auf einer Leitung befindet, kann mittels einer Analyse von während des Fehlereintritts erfassten Messgrößen, z.B. Strömen und Spannungen, eingegrenzt werden. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert daraufgelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind, insbesondere für Energieübertragungsleitungen, Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben. Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden.

Eine verbesserte Genauigkeit bei der Fehlerortung auf Übertragungsleitungen lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht.

Die genannten Fehlerortungsverfahren eignen sich besonders für lineare Netztopologien ohne Verzweigungen, also für Leitungen mit zwei Leitungsenden. Für Energieverteilnetze, bei denen von einem Hauptstrang meist eine Mehrzahl von Abzweigen abgeht, von denen aus Endverbraucher und Kleinerzeuger mit dem Energieversorgungsnetz verbunden werden, eigenen sich solche Fehlerortungsverfahren nur bedingt.

Bei solchen ohnehin verzweigten Netzen erfordern eine schnelle Integration von regenerativen Energiequellen in sowie der Ausbau von bestehenden Energienetzen in vielen Situationen jedoch den Aufbau von noch stärker verzweigten Netztopologien.

Zur Fehlerortung in Energieverteilnetzen werden heutzutage beispielsweise gestaffelte Schaltertopologien eingesetzt (vgl. z.B. US 9,279,846 B2). Dabei wird ein Fehler im Energieverteilnetz mit einem an der Einspeisung am Hauptstrang angeordneten Leistungsschalter abgeschaltet und daraufhin die Leitung durch Öffnen mehrerer Sektionsschalter in Leitungsabschnitte unterteilt. Nach Wiedereinschalten der Stromversorgung durch den Leistungsschalter wird die Leitung sektionsweise wieder zugeschaltet, bis der Fehler erneut auftritt. Der Fehler wird auf dem zuletzt zugeschalteten Leitungsabschnitt erkannt. Eine genauere Bestimmung der Fehlerortes, insbesondere auch eine Unterscheidung von Fehlern auf dem Hauptstrang und den Abzweigen, ist meist nicht möglich oder kann nur durch zusätzliche Technik realisiert werden.

Mit bisheriger Technik könnte auch durch den zusätzlichen Einsatz von Erdschlusswischer-Relais die fehlerhafte Leitung festgestellt werden. Dazu müsste jedoch an jedem Abzweig ein Gerät mit Erdschlusswischerfunktion installiert sein, was mit erheblichen Kosten verbunden ist. Deshalb werden Fehlerortungssysteme nach dem Erdschlusswischer-Prinzip nur dann eingesetzt, wenn eine schnelle Erkennung der fehlerbehafteten Leitung für die Versorgungszuverlässigkeit unbedingt erforderlich ist.

Ferner ist aus der Veröffentlichung "Electric Transmission Fault Location Techniques Using Traveling Wave Method and Discrete Wavelet Transform" von FLUTY WESLEY ET AL.,2020 CLEMSON UNIVERSITY POWER SYSTEMS CONFERENCE (PSC), IEEE, 10. März 2020, Seiten 1-8, ein Verfahren zur Fehlerortung mittels Wanderwellen bekannt.

Der Erfindung die Aufgabe zugrunde, eine Möglichkeit für eine Fehlerortung in einem elektrischen Energieverteilnetz anzugeben, die mit einer möglichst geringen Anzahl an Messgeräten durchgeführt werden kann.

Diese Aufgabe wird durch ein im Anspruch 1 beschriebenes Verfahren der eingangs angegebenen Art gelöst, bei dem anhand der ersten und der zweiten Messwerte das Eintreffen von jeweiligen Wanderwellen erkannt wird, die auf einen im Energieverteilnetz aufgetretenen Fehler hinweisen, und die Zeitpunkte des jeweiligen Eintreffens der Wanderwelle gespeichert werden, mittels der jeweiligen Zeitpunkte von beiden Messstellen eine erste Fehlerortung unter Erzeugung eines ersten Fehlerortwertes durchgeführt wird, mittels der Zeitpunkte nur der ersten Messstelle eine zweite Fehlerortung unter Erzeugung eines zweiten Fehlerortwertes durchgeführt wird, und der Fehlerort basierend auf dem ersten Fehlerortwert und dem zweiten Fehlerortwert ermittelt wird. Der besondere Vorteil des erfindungsgemäßen Verfahrens besteht darin, dass es die Möglichkeiten einer Fehlerortung nach dem Wanderwellenprinzip nutzt und dabei eine zweiseitige Fehlerortung mit einer einseitigen Fehlerortung kombiniert. Während nämlich die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- und Spannungssignale die beim Fehler entstehenden hochfrequenten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden. Ein Beispiel eines solchen Fehlerortungsverfahrens kann der US-Patentschrift US 8,655,609 B2 entnommen werden.

Neben der hohen Genauigkeit stellt auch die Geschwindigkeit der Fehlerortung nach dem Wanderwellenprinzip einen bedeutenden Vorteil des erfindungsgemäßen Verfahrens dar. Durch die Verknüpfung der Fehlerortung von beiden Seiten mit derjenigen von nur einer Seite kann allein mit zwei Geräten der Fehlerort mit großer Genauigkeit bestimmt werden.

Eine vorteilhafte Ausführungsform des erfindungsgemäßen Verfahrens sieht vor, dass die erfassten Messwerte in modale Komponenten zerlegt werden, wobei zumindest zwei der Komponenten unterschiedliche Ausbreitungsgeschwindigkeiten entlang der Leitungen des Energieverteilnetzes aufweisen, und für die erste und die zweite Fehlerortung zumindest teilweise unterschiedliche modale Komponenten herangezogen werden.

Auf diese Weise können vorteilhaft unterschiedliche Ausbreitungsgeschwindigkeiten der verschiedenen Moden zur genaueren Fehlerortung genutzt werden.

Konkret kann in diesem Zusammenhang vorgesehen sein, dass für die erste Fehlerortung zur Bildung des ersten Fehlerortwertes jeweilige Zeitpunkte verwendet werden, zu denen die jeweils erste Wellenflanke einer modalen Null-Komponente der jeweiligen Wanderwelle an der ersten und der zweiten Messstelle eingetroffen ist.

Bei einer modalen Zerlegung in $\alpha$-, $\beta$- und Null-Komponenten eignet sich die messtechnisch einfach erfassbare Null-Komponente für die Zwecke der zweiseitigen Fehlerortung besonders gut.

Alternativ oder zusätzlich kann in diesem Zusammenhang vorgesehen sein, dass für die zweite Fehlerortung zur Bildung des zweiten Fehlerortwertes jeweilige Zeitpunkte verwendet werden, zu denen die jeweils erste Wellenflanke einer modalen Null-Komponente und einer modalen $\alpha$- oder $\beta$-Komponente der Wanderwelle an der ersten Messstelle eingetroffen ist.

Da die Null-Komponente einerseits und die $\alpha$- und $\beta$-Komponente andererseits deutlich voneinander unterschiedliche Ausbreitungsgeschwindigkeiten aufweisen, eignen sie sich gut für die Zwecke einer einseitigen Fehlerortung.

Gemäß einer vorteilhaften Ausführungsform des erfindungsgemäßen Verfahrens kann zudem vorgesehen sein, dass für den Fall, dass der erste Fehlerortwert und der zweite Fehlerortwert übereinstimmen, der entsprechende Ort auf dem Hauptstrang als Fehlerort bestimmt wird.

Mit der zweiseitigen Fehlerortung können nämlich nur eindeutig solche Fehler geortet werden, die auf dem Hauptstrang des Energieverteilnetzes liegen. Fehler, die auf einem der Abzweige liegen, werden aufgrund des Verhaltens der Wanderwellen, als am jeweiligen Ort des Abzweigs auf dem Hauptstrang liegend erkannt. Zu einem entsprechenden Ergebnis kommt man bei Verwendung der einseitigen Fehlerortung allein. Damit kann aus einer Übereinstimmung der Ergebnisse auf einen auf dem Hauptstrang liegenden Fehler geschlossen werden.

Eine weitere vorteilhafte Ausführungsform des erfindungsgemäßen Verfahrens sieht vor, dass für den Fall, dass der erste Fehlerortwert vom zweiten Fehlerortwert abweicht, der Fehlerort als auf einem der Abzweige liegend erkannt wird.

In einem solchen Fall werden nämlich wie oben erläutert unterschiedliche Ergebnisse der einseitigen und der zweiseitigen Fehlerortung vorliegen.

Konkret kann in diesem Zusammenhang vorgesehen sein, dass der fehlerbehaftete Abzweig, auf dem der Fehlerort liegt, durch den ersten Fehlerortwert angegeben wird.

Da nämlich die zweiseitige Fehlerortung den Ursprung der Wanderwelle als auf dem Ort des Abzweigs liegend erkennt, gibt das Ergebnis der zweiseitigen Fehlerortung einen Hinweis auf den fehlerbehafteten Abzweig.

Konkret kann zudem in diesem Zusammenhang vorgesehen sein, dass der konkrete Fehlerort auf dem fehlerbehafteten Abzweig als Differenz aus dem zweiten Fehlerortwert und dem ersten Fehlerortwert bestimmt wird.

Während nämlich die zweiseitige Fehlerortung wie erwähnt die Entfernung zum Abzweig auf dem Hauptstrang angibt, lässt sich mit der einseitigen Fehlerortung die vollständige Entfernung bis zur tatsächlichen Fehlerstelle bestimmen. Die Differenz ergibt dann den Fehlerort auf dem Abzweig (vom Beginn des Abzweigs gesehen).

Eine weitere vorteilhafte Ausführungsform des erfindungsgemäßen Verfahrens sieht zudem vor, dass als Messwerte hochfrequente Strom- und/oder Spannungsmesswerte an der jeweiligen Messstelle verwendet werden.

Hierzu kann beispielsweise auf bereits vorhandene Strom- oder Spannungswandler zurückgegriffen werden.

Schließlich ist gemäß einer weiteren vorteilhaften Ausführungsform des erfindungsgemäßen Verfahrens vorgesehen, dass die Messwerte in einem Ringpuffer abgespeichert werden, dessen Inhalt festgeschrieben wird, sobald im Verlauf zumindest eines der Messwerte eine Wanderwelle erkannt worden ist. Auf diese Weise kann sehr einfach die Messwerthistorie vor Eintreffen der Wanderwelle berücksichtigt werden.

Die oben genannte Aufgabe wird auch durch eine im Anspruch 11 beschriebene Einrichtung zum Ermitteln eines Fehlerortes in einem elektrischen Energieverteilnetz gelöst, wobei das Energieverteilnetz zumindest eine Einspeisung sowie Leitungen in Form eines Hauptstrangs und einer Mehrzahl von vom Hauptstrang abgehenden Abzweigen aufweist, wobei die Einrichtung eine Auswerteinrichtung aufweist, die dazu eingerichtet ist, anhand von Zeitpunkten, zu denen jeweilige Wanderwellen an einer ersten und einer zweiten Messstelle des Energieverteilnetzes eingetroffen sind, den Fehlerort eines im Energieverteilnetz aufgetretenen Fehlers zu ermitteln.

Erfindungsgemäß ist vorgesehen, dass die Auswerteinrichtung dazu eingerichtet ist, mittels der jeweiligen Zeitpunkte von beiden Messstellen eine erste Fehlerortung unter Erzeugung eines ersten Fehlerortwertes durchzuführen, die Auswerteinrichtung dazu eingerichtet ist, mittels der Zeitpunkte nur der ersten Messstelle eine zweite Fehlerortung unter Erzeugung eines zweiten Fehlerortwertes durchzuführen, und dass die Auswerteinrichtung dazu eingerichtet ist, den Fehlerort basierend auf dem ersten Fehlerortwert und dem zweiten Fehlerortwert zu ermitteln.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Konkret kann hinsichtlich der Einrichtung vorgesehen sein, dass die Einrichtung eine zentrale Datenverarbeitungseinrichtung ist, die eine Kommunikationseinheit aufweist, die zum Empfang von Informationen eingerichtet ist, die die Zeitpunkte des Eintreffens der Wanderwellen an der ersten und der zweiten Messstelle angeben.

Bei der zentralen Datenverarbeitungseinrichtung kann es sich z.B. um einen Computer in einer Leitstelle des Energieverteilnetzes handeln.

Konkret kann in diesem Zusammenhang aber auch vorgesehen sein, dass die Einrichtung eine Cloud-Datenverarbeitungseinrichtung ist.

Damit kann das oben beschriebene Verfahren auf einer Cloud-Plattform ausgeführt werden und die Fehlerortung als Cloud-Service angeboten werden. Als Cloud-Plattform kann beispielsweise die Siemens Mindsphere © verwendet werden.

Alternativ kann aber auch vorgesehen sein, dass die Einrichtung eine interne Messeinrichtung erfasst, die dazu eingerichtet ist, erste Messwerte an der ersten Messstelle des Energieverteilnetzes zu erfassen und den jeweiligen Zeitpunkt des Eintreffens einer Wanderwelle zu bestimmen, und die Einrichtung ein Kommunikationsmodul aufweist, das dazu eingerichtet ist, eine Information über den jeweiligen Zeitpunkt des Eintreffens einer Wanderwelle an der zweiten Messstelle von einer entfernt angeordneten Messeinrichtung zu empfangen.

Hierbei kann vorgesehen sein, dass an nur einer der beiden Messstellen eine Einrichtung mit einer Messeinrichtung vorgesehen ist, die von einer Messeinrichtung von der anderen Messstelle deren Messwerte bzw. direkt die Informationen über die Zeitpunkte übermittelt erhält. Alternativ können auch an beiden Messstellen Einrichtungen mit Messeinrichtungen vorgesehen sein, so dass der Fehlerort an beiden Messstellen bestimmt werden kann. Dazu tauschen die Einrichtungen an beiden Messstellen Informationen über die relevanten Zeitpunkte untereinander aus.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen.

Hierzu zeigen

Figur 1    ein schematisches Beispiel eines Energieverteilnetzes mit einer linearen Topologie (strahlenförmige Topologie);

Figur 2    ein schematisches Beispiel eines Energieverteilnetzes mit einer ringförmigen Topologie;

Figur 3    ein Verfahrensfließbild zur Erläuterung eines Ausführungsbeispiels eines Verfahrens zur Fehlerortung in einem Energieverteilnetz;

Figur 4    ein Verfahrensfließbild zur Erläuterung eines Details des Ausführungsbeispiels gemäß Figur 3;

Figur 5    ein beispielhaftes Netzbild eines Energieverteilnetzes mit einem Fehler auf dem Hauptstrang;

Figur 6    das Netzbild der Figur 5 mit einem Fehler auf einem ersten Abzweig;

Figur 7    das Netzbild der Figur 5 mit einem Fehler auf einem zweiten Abzweig;

Figur 8    das Netzbild der Figur 7 zur Erläuterung der Fehlerortung;

Figur 9    ein weiteres Netzbild zur Erläuterung eines Ausführungsbeispiels zur Fehlerortung;

Figur 10   Diagramme zur Darstellung von beispielhaften Wanderwellen an zwei Messstellen; und

Figur 11   Diagramme zur Darstellung von beispielhaften Wanderwellen an einer Messstelle.

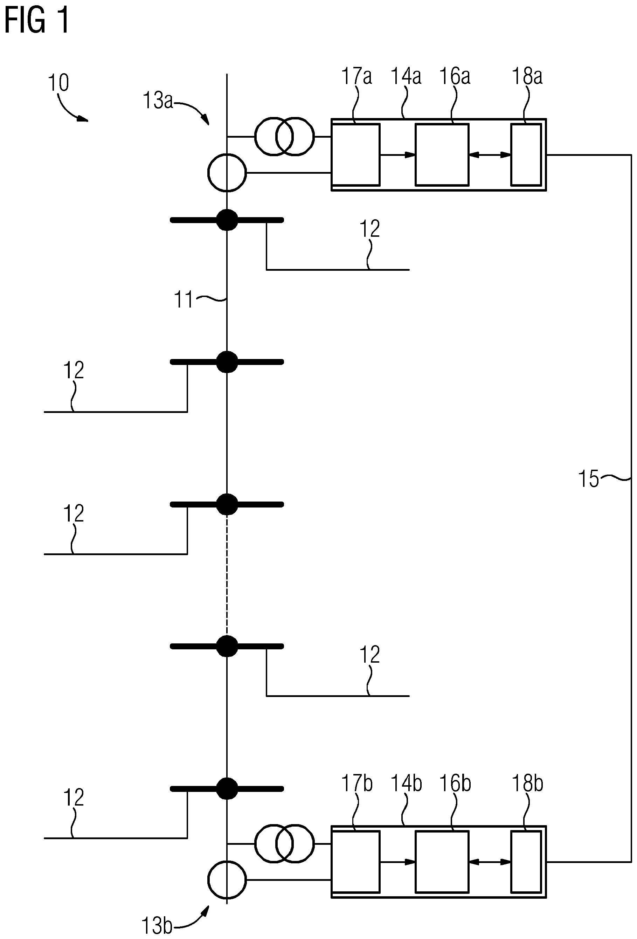

In Figur 1 ist beispielhaft ein elektrisches Energieverteilnetz 10 mit strahlenförmiger Topologie gezeigt, das einen Hauptstrang 11 und mehrere Abzweige 12 umfasst. Um einen Fehler, z.B. einen Kurzschluss oder einen Erdschluss, in dem Verteilnetz 10 zu lokalisieren, werden an Messstellen 13a und 13b mit Einrichtungen 14a und 14b hochfrequente Strom- und/oder Spannungssignale erfasst und daraufhin ausgewertet, ob sie auf das Eintreffen von Wanderwellen hinweisen. Zum Datenaustausch sind die beiden Einrichtungen 14a, 14b mittels Kommunikationsmodulen 18a, 18b über eine Kommunikationsverbindung 15, die drahtlos oder drahtgebunden ausgestaltet sein kann, miteinander verbunden. In Figur 1 umfassen die Einrichtungen 14a, 14b interne Messeinrichtungen 17a, 17b zum Erfassen der hochfrequenten Strom- und/oder Spannungssignale und eine Auswerteinrichtung 16a, 16b, die anhand der aufgenommenen Messwerte das Eintreffen von Wanderwellen erkennt und mit einem hochgenauen Zeitstempel versieht. Auf diese Weise werden an beiden Messstellen 13a, 13b Zeitpunkte ermittelt, zu denen dort Wanderwellen eintreffen. Die Information über die Zeitpunkte wird über die Kommunikationsverbindung 15 ausgetauscht. Aus den Informationen von beiden Messstellen 13a, 13b können die Einrichtungen 14a, 14b den Fehlerort ermitteln.

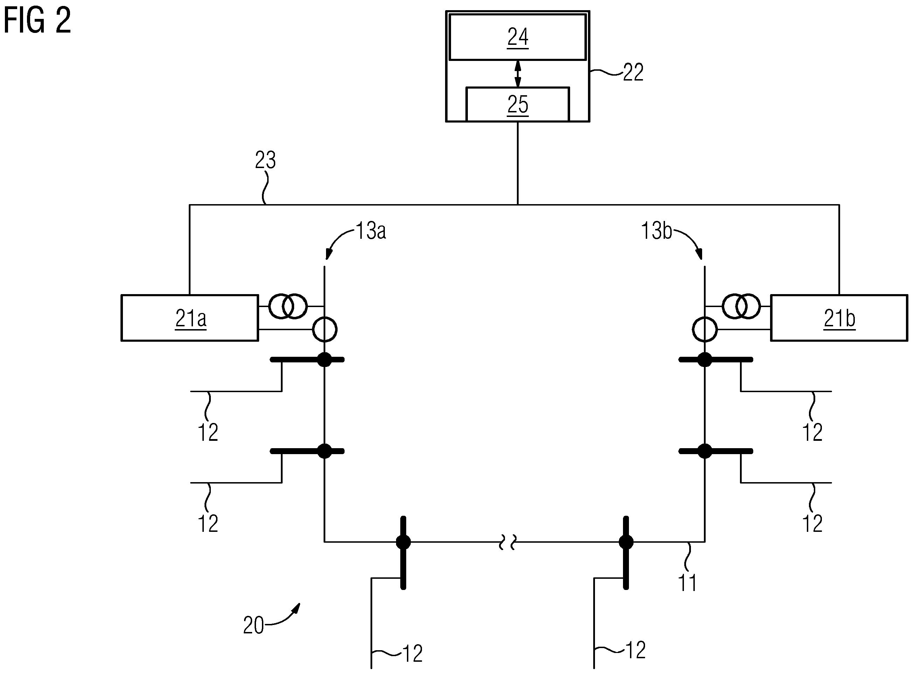

Figur 2 zeigt ein anderes Beispiel eines elektrischen Energieverteilnetzes 20, das eine ringförmige Topologie aufweist. Auch das Energieverteilnetz 20 der Figur 2 weist einen Hauptstrang 11 und mehrere Abzweige 12 auf. Um einen Fehler in dem Verteilnetz 20 zu lokalisieren, werden an Messstellen 13a und 13b mit Messeinrichtungen 21a und 21b hochfrequente Strom- und/oder Spannungssignale erfasst und daraufhin ausgewertet, ob sie auf das Eintreffen von Wanderwellen hinweisen. Die beiden Messeinrichtungen 21a, 21b sind über eine Kommunikationsverbindung 23, die drahtlos oder drahtgebunden ausgestaltet sein kann, mit einer Kommunikationseinheit 25 einer Einrichtung 22 zur Fehlerortung verbunden, die beispielsweise als zentrale Datenverarbeitungseinrichtung oder als Cloud-Computingsystem ausgebildet sein kann. In Figur 2 werden mit den Messeinrichtungen 21a, 21b die hochfrequenten Strom- und/oder Spannungssignale erfasst und es wird anhand der aufgenommenen Messwerte das Eintreffen von Wanderwellen erkannt. Dabei werden an beiden Messstellen 13a, 13b Zeitpunkte ermittelt, zu denen dort Wanderwellen eintreffen. Die Information über die Zeitpunkte wird über die Kommunikationsverbindung 23 an die Einrichtung 22 übermittelt. Aus den Informationen von beiden Messstellen 13a, 13b kann eine Auswerteinrichtung 24 der Einrichtung 22 den Fehlerort ermitteln.

Bei den Energieverteilnetzen 10, 20 der Figuren 1 und 2 handelt es sich um beispielhafte Topologien mehrphasiger (vorzugsweise dreiphasiger) Energieverteilnetze. Vorzugsweise sind die Sternpunkte der Netze gelöscht bzw. isoliert. Der Vorteil einer gelöschten bzw. isolierten Netzausführung besteht darin, dass die Stromversorgung auch während eines Erdschlusses aufrechterhalten bleiben kann.

Typischerweise werden die einzelnen Abzweige 12 von Verteilnetzen nicht überwacht. Aufwendige Schutzeinrichtungen, wie sogenannte Erdschlusswischer-Relays, Erdschluss-Relays nach der wattmetrischen Messmethode bzw. Erdstromdifferentialschutz-Relays sind meist nur in Übertragungsnetzen vorgesehen und werden in Verteilnetzen aus Kostengründen sparsam oder gar nicht eingesetzt. Somit ist auch eine genaue Ortung des Fehlers mit herkömmlichen Methoden kaum oder gar nicht möglich. Häufig erlöschen Erdschlüsse zudem von selbst. In einem solchen Fall lässt sich oft nur eine Aussage dahingehend treffen, entlang welchen Hauptstrangs der Erdschluss liegt. Nur im Fall von Dauererdschlüssen (meistens Erdschlüsse im Kabel) und/oder bei Einsatz zusätzlicher Messtechnik lassen sich bisher solche Erdschlüsse orten.

Vorliegend wird ein Verfahren vorgestellt, wie sich mit wenigen Messgeräten, nämlich lediglich zwei Messgeräten pro Hauptstrang, eine Ortung eines Fehlers mit hoher Genauigkeit durchführen lässt.

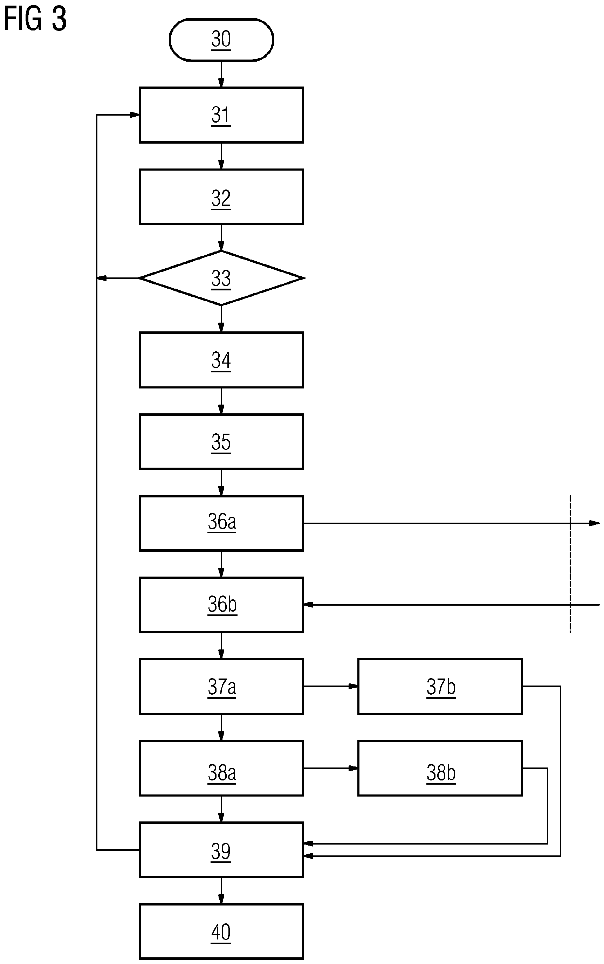

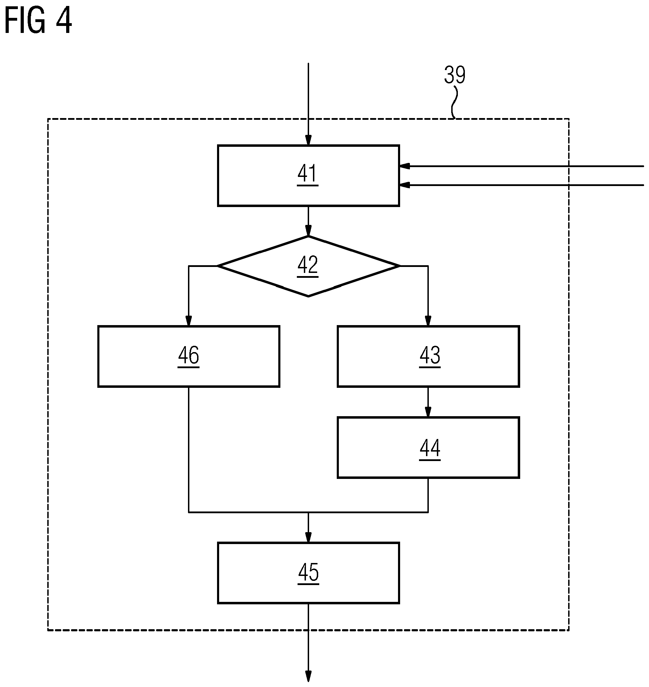

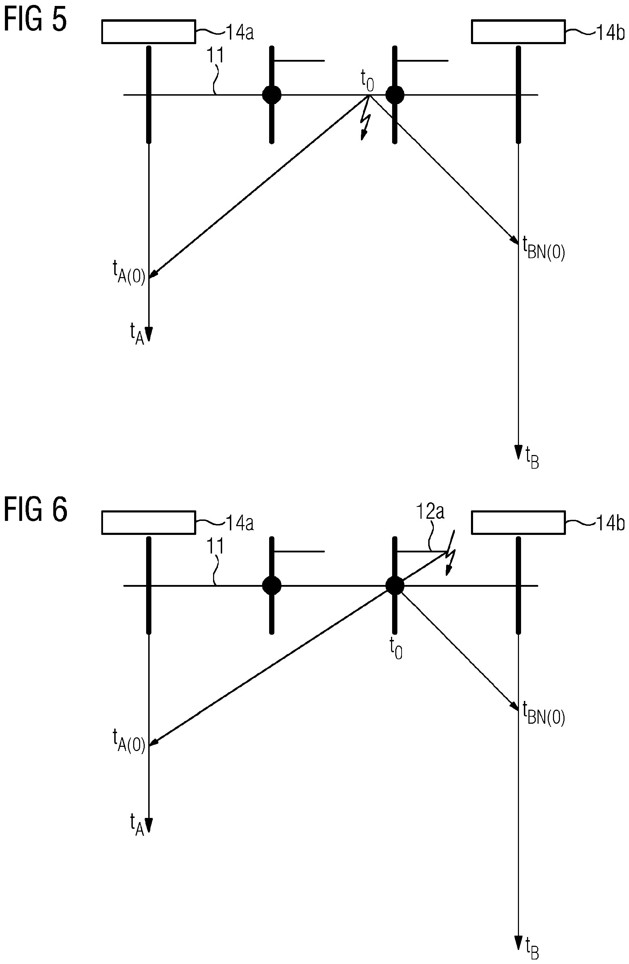

Anhand der Fließbilder der Figuren 3 und 4 sowie der Netzdarstellungen in Form sogenannter "Propagation-Diagramme" der Figuren 5 bis 8 soll nachfolgend die Vorgehensweise bei der Fehlerortung näher erläutert werden.

Hierzu zeigt Figur 3 ein Verfahrensfließbild, in dem ein Ausführungsbeispiel eines Verfahrens zur Ortung eines Fehlers in einem elektrischen Energieverteilnetz dargestellt ist. Die dargestellten Verfahrensschritte werden von einer oder beiden Einrichtungen 14a, 14b (Figur 1) bzw. den Messeinrichtungen 21a, 21b und der Einrichtung 22 (Figur 2) durchgeführt.

Das Verfahren beginnt bei Schritt 30, in dem Strom- und/oder Spannungssignale an den Messstellen 13a, 13b erfasst und in digitale Abtastwerte umgesetzt werden. Die Abtastrate zur Bildung Abtastwerte liegt hierbei vergleichsweise hoch (etwa im Bereich einiger Megahertz), um die hochfrequenten Signale zur Erkennung von Wanderwellen abtasten zu können. Nach einer Bandpassfilterung der Abtastwerte (Schritt 31) werden die Abtastwerte der Signale in einen Ringpuffer eingespeist (Schritt 32). Dabei werden die jeweils ältesten Abtastwerte des Signals überschrieben, wenn der Ringpuffer seinen maximalen Füllstand erreicht hat.

Ausgehend vom jeweils neuesten Abtastwert im Ringpuffer wird in einem Triggerbaustein geprüft (Schritt 33), ob eine Wanderwelle eingetroffen ist. Dies kann vorzugsweise durch Erkennung einer Wellenfront erfolgen, die an der entsprechenden Messstelle eintrifft. Beispielsweise können hierzu Schwellenwertvergleiche oder Mustererkennungen durchgeführt werden, um einen Sprung im erfassten Signal zu erkennen. Der Triggerbaustein wertet jede Phase des Energieverteilnetzes einzeln aus. Wird in mindestens einer Phase das Eintreffen einer Wanderwelle als Triggerereignis erkannt, wird der komplette Ringpuffer "eingefroren" und die Abtastwerte der Phasengrößen werden in modale Komponenten ($\alpha$-Komponente, $\beta$-Komponente, Null-Komponente) zerlegt (Schritt 34). Hierzu kann beispielsweise die sogenannte "Clarke-Transformation" eingesetzt werden.

Die Zeitpunkte, zu denen die jeweils ersten Wellenfronten der einzelnen Moden an den Messstellen eingetroffen sind, werden mit internen Zeitgebern bestimmt und abgespeichert (Schritt 35).

In einem folgenden Schritt 36a wird die jeweilige Information über den Zeitpunkt des Eintreffens der Wanderwelle an eine Einrichtung zur Fehlerortung übertragen. Dies kann bei einer integrierten Mess- und Fehlerortungseinrichtung die Einrichtung an der anderen Messstelle sein (Beispiel Figur 1) oder bei einer zentralen Fehlerortbestimmung die zentrale Einrichtung (Beispiel Figur 2). Sofern die Fehlerortung dezentral mit integrierten Einrichtungen direkt an der Messstelle erfolgt, wird in einem folgenden Schritt 36b die Information über den jeweiligen Zeitpunkt des Eintreffens der Wanderwelle an der anderen Messstelle empfangen. Im Beispiel der Figur 3 soll davon ausgegangen werden, dass die Fehlerortung dezentral durchgeführt wird, so dass in Schritten 36a und 36b zwischen den beiden Einrichtungen an den Messstellen die Informationen über die Zeitpunkte, zu denen die Wanderwellen an den jeweiligen Messstellen eingetroffen sind, ausgetauscht werden. Nach den Schritten 36a und 36b liegen die Informationen über alle Zeitpunkte in beiden Einrichtungen vor.

Mit diesen Informationen wird in einem folgenden Schritt 37a eine zweiseitige Fehlerortung durchgeführt. Dabei wird ein erster Fehlerortwert ermittelt und temporär gespeichert (Schritt 37b). Bei der zweiseitigen Fehlerortung wird unter Verwendung der modalen Nullkomponenten an beiden Messstellen die Position des Fehlers auf dem Hautstrang ermittelt bzw. die Position auf dem Hauptstrang bestimmt, an dem der fehlerbehaftete Abzweig abgeht.

Unter Verwendung der Zusammenhänge von Zeit und Strecke, die eine Wanderwelle benötigt, um vom Fehlerort zu einer Messstelle zu kommen, lassen sich für den Hauptstrang folgende Formeln aufstellen:

$$x = \left( t_{A(0)} - t_0 \right) \cdot v_0$$

$$L - x = \left( t_{B(0)} - t_0 \right) \cdot v_0$$

Hierbei bezeichnen x den möglichen Fehlerort (als Entfernung von Messstelle A aus gesehen) sowie L die Länge des Hauptstranges (Strecke zwischen den beiden Messstellen A und B), $t_0$ die unbekannte Eintrittszeit des Fehlers und $t_{A(0)}$ und $t_{B(0)}$ die ermittelten Zeitpunkte des Eintreffens der modalen Null-Komponenten der Wanderwellen (jeweils erste Wellenfronten) an beiden Messstellen A und B. Die Messeinrichtungen sind dabei zeitlich synchronisiert, so dass vergleichbare Zeitpunkte ermittelt werden können.

Durch Kombination der beiden oben genannten Gleichungen erhält man den ersten Fehlerortwert:

$$x = \frac{L + \left( t_{A(0)} - t_{B(0)} \right) \cdot v_0}{2}$$

Dieser Zusammenhang ist in dem Bergeron-Diagramm der Figur 5 dargestellt, die einen Fehler auf dem Hauptstrang 11 zeigt, von dem aus sich Wanderwellen zu den beiden Messstellen ausbreiten und dort mit den Einrichtungen 14a und 14b erfasst werden.

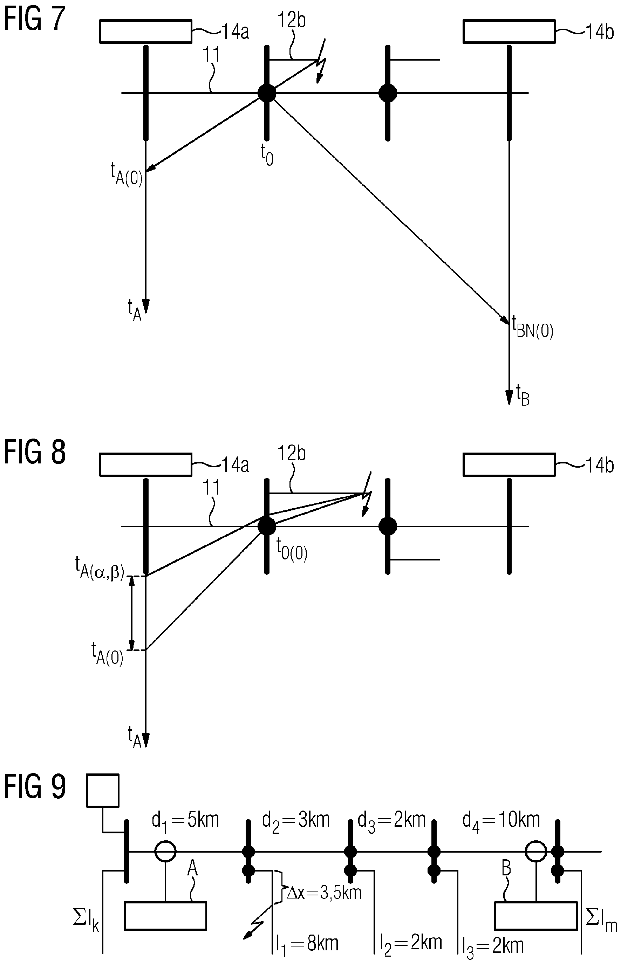

Figuren 6 und 7 zeigen weitere Propagation-Diagramme, bei denen die Ausbreitung der Wanderwellen jeweils von dem Ort ausgeht, an dem ein Abzweig angeordnet ist. So ergibt die zweiseitige Fehlerortung nach obiger Gleichung für Figur 6 einen ersten Fehlerortwert, der mit dem Ort des Abzweiges 12a übereinstimmt. Dies bedeutet, dass der Fehler entweder direkt an diesem Ort auf dem Hauptstrang 11 oder irgendwo auf diesem Abzweig 12a liegt. Entsprechend

EP 3 968 037 B1

ergibt die zweiseitige Fehlerortung für Figur 7 einen ersten Fehlerortwert, der mit dem Ort des Abzweiges 12b übereinstimmt. Dies bedeutet, dass der Fehler entweder direkt an diesem Ort auf dem Hauptstrang 11 oder irgendwo auf diesem Abzweig 12b liegt.

Liegt zwischen den Einrichtungen längs Hauptstranges 11 eine gemischte Strecke aus Kabeln und Freileitungen vor, muss dies auch bei der Fehlerortung berücksichtigt werden. Dazu muss eine zusätzliche Information bezüglich der betroffenen Segmente herangezogen werden, die beispielsweise von Fehlerindikatoren erzeugt werden kann.

Um den Fehlerort genau ermitteln zu können, wird gemäß einem folgenden Schritt 38a (siehe Figur 3) eine einseitige Fehlerortung durchgeführt und in Schritt 38b ein zweiter Fehlerortwert erzeugt. Bei der einseitigen Fehlerortung wird die Tatsache ausgenutzt, dass sich die modalen Null-Komponente der Wanderwellen von den $\alpha$- und $\beta$-Komponenten hinsichtlich ihrer Ausbreitungsgeschwindigkeit unterscheidet. Somit lässt sich anhand der unterschiedlichen Zeitpunkte des Eintreffens der Wanderwellen der modalen Komponenten die Entfernung zum Fehlerort von einer Messstelle bestimmen.

Die Ausbreitungsgeschwindigkeiten von modalen Komponenten (Moden) lassen sich auf verschiedene Wege bestimmen, wobei rechnerische und messtechnische Wege unterschieden werden können.

Bei der Berechnung kann man auf bewährte Transformationsmethoden zurückgegriffen werden, beispielsweise mittels einer Eigenwertanalyse bei symmetrischen Impedanz- und Admittanzmatrizen, mittels der Clarke-Transformation oder mittels der Dommel-Transformation.

Eine messtechnische Ermittlung setzt bei bekannter Leitungslänge einen kontrollierten Wanderwelleneffekt voraus. Beispielsweise können in gelöschten bzw. isolierten Netzen Erdschlussversuche oder Schalthandlungen durchgeführt werden, bei denen sich transiente Effekte ergeben, die für eine Bestimmung der Geschwindigkeiten aller Moden ausreichend sind.

Für die einseitige Fehlerortung müssen die Laufzeiten der Wanderwelle vom Ort des fehlerbehafteten Abzweiges bis zur Messstelle berücksichtigt werden:

$$t_{Abzweig(i)} = t_{A(\alpha,\beta)} - \frac{x}{v_{(\alpha,\beta)}} - \frac{\Delta x}{v_{Abzweig(\alpha,\beta)}}$$

$$t_{Abzweig(i)} = t_{A(0)} - \frac{x}{v_{(0)}} - \frac{\Delta x}{v_{Abzweig(0)}}$$

Der Wert x steht hierbei für den zweiten Fehlerortwert. Da man einerseits die modale Null-Komponente und andererseits die modalen $\alpha$- bzw. $\beta$-Komponenten betrachten kann, lässt sich der Zeitpunkt des Fehlereintritts $t_{Abzweig(i)}$ für die jeweiligen modalen Komponenten abschätzen. Dies zeigt Figur 8. Die Abschätzung ist nur dann plausibel, wenn man den tatsächlichen Fehlerort $\Delta x$ am Abzweig ($\Delta x$ = Entfernung vom Ort des Abzweigs am Hauptstrang bis zum Fehlerort als Differenz des ersten und des zweiten Fehlerortwertes) kennt. Da der Fehlerort $\Delta x$ gesucht ist, können die obigen Gleichungen gleichgesetzt werden:

$$t_{A(0)} - \frac{x}{v_{(0)}} - \frac{\Delta x}{v_{Abzweig(0)}} = t_{A(\alpha,\beta)} - \frac{x}{v_{(\alpha,\beta)}} - \frac{\Delta x}{v_{Abzweig(\alpha,\beta)}}$$

$$\frac{\Delta x}{v_{Abzweig(\alpha,\beta)}} - \frac{\Delta x}{v_{Abzweig(0)}} = t_{A(\alpha,\beta)} - t_{A(0)} - \frac{x}{v_{(\alpha,\beta)}} + \frac{x}{v_{(0)}}$$

$$\Delta x \left( \frac{1}{v_{Abzweig(\alpha,\beta)}} - \frac{1}{v_{Abzweig(0)}} \right) = t_{A(\alpha,\beta)} - t_{A(0)} - x \left( \frac{1}{v_{(\alpha,\beta)}} - \frac{1}{v_{(0)}} \right)$$

Definiert man $\Delta t_{A(\alpha,\beta,0)}$ als Zeitdifferenz zwischen den eintreffenden Wanderwellen der Null- bzw. $\alpha$-, $\beta$-Komponente, so ergibt sich nach kurzem Umformen:

7

$$\Delta x \left( \frac{v_{Abzweig(0)} - v_{Abzweig(\alpha,\beta)}}{v_{Abzweig(\alpha,\beta)} v_{Abzweig(0)}} \right) = \Delta t_{A(\alpha,\beta,0)} - x \left( \frac{v_{(0)} - v_{(\alpha,\beta)}}{v_{(\alpha,\beta)} v_{(0)}} \right)$$

An der Stelle x setzt man den mittels des zweiseitigen Fehlerortungsverfahrens bereits ermittelten ersten Fehlerortwert ein, der im Falle eines Fehlers auf dem Abzweig der Entfernung $d_{Abzweig(i)}$ von der Messstelle entspricht:

$$\Delta x \left( \frac{v_{Abzweig(0)} - v_{Abzweig(\alpha,\beta)}}{v_{Abzweig(\alpha,\beta)} v_{Abzweig(0)}} \right) = \Delta t_{A(\alpha,\beta,0)} - d_{Abzweig(i)} \left( \frac{v_{(0)} - v_{(\alpha,\beta)}}{v_{(\alpha,\beta)} v_{(0)}} \right)$$

$$\Delta x \cdot k_{v\_Abzweig(i)} = \Delta t_{A(\alpha,\beta,0)} - d_{Abzweig(i)} \cdot k_{v\_Hauptstrang}$$

Dabei bedeuten:

$$k_{v\_Abzweig\prime(i)} = \left( \frac{v_{Abzweig(0)} - v_{Abzweig(\alpha,\beta)}}{v_{Abzweig(\alpha,\beta)} v_{Abzweig(0)}} \right)$$

$$k_{v\_Hauptstrang} = \left( \frac{v_{(0)} - v_{(\alpha,\beta)}}{v_{(\alpha,\beta)} v_{(0)}} \right)$$

Somit ergibt sich die Entfernung Δx auf dem fehlerbehafteten Abzweig i zu:

$$\Delta x = \frac{\Delta t_{A(\alpha,\beta,0)} - d_{Abzweig(i)} \cdot k_{v\_Hauptstrang}}{k_{v\_Abzweig(i)}}$$

Falls sich der Hauptstrang aus unterschiedlichen Abschnitten zusammensetzt, die abweichende Parameter aufweisen, wird die Berechnung des Fehlerortes nach einer leicht abgewandelten Formel durchgeführt:

$$\Delta x = \frac{\Delta t_{A(\alpha,\beta,0)} - \sum_m^M d_{Abschnitt(m)} \cdot k_{v\_Abschnitt(m)}}{k_{v\_Abzweig(i)}}$$

Für die Berechnung des Fehlerorts, werden die aufgestellten Gleichungen miteinander kombiniert, indem man aus einer Gleichung die Unbekannte $t_0$ ermittelt und in die andere Gleichung einsetzt.

In Schritt 39 (vgl. Figur 3) wird unter Verwendung des ersten und des zweiten Fehlerortwertes überprüft, ob der Fehlerort auf dem Hauptstrang oder auf einem der Abzweige liegt. Dies wird unter Hinzunahme von Figur 4 näher erläutert, die quasi eine Detailansicht von Schritt 39 darstellt.

Zunächst werden einem Block 41 der erste und der zweite Fehlerortwert zugeführt. In einem Vergleichsblock 42 wird geprüft, ob beide Fehlerortwerte im Rahmen der Messgenauigkeit identisch sind. Ist dies der Fall (Block 46), so liegt der Fehler auf dem Hauptstrang und die identischen Fehlerortwerte geben den tatsächlichen Fehlerort an. Sind die Fehlerortwerte hingegen nicht identisch, so gibt in Block 43 der erste Fehlerortwert den Ort des Abzweigs an, auf dem der Fehler liegt. Die Differenz aus dem zweiten Fehlerortwert und dem ersten Fehlerortwert gibt in Block 44 die Entfernung vom Ort des Abzweigs an, wo der tatsächliche Fehlerort liegt. Dies ist in den obigen Gleichungen als Δx bezeichnet. In Block 45 wird der Fehlerort ausgangsseitig bereitgestellt.

Das Verfahren wird gemäß Figur 3 mit Schritt 40 beendet, in dem der Fehlerort ausgegeben wird. Der Fehlerort kann beispielsweise als Telegramm an eine Leitstelle übermittelt werden und/oder auf einem Display angezeigt werden.

Für die Erfassung von Wanderwellenfronten können sowohl Signale von Strömen als auch von Spannungen verwendet werden. Der Erdstrom in einem gelöschten bzw. isolierten System wird mittels empfindlicher Wandler erfasst.

Daher wird es empfohlen, die zugehörige Null-Modenkomponente als Basis für die Fehlerortung zu nehmen. Falls nur die Stromwandler benutzt werden, muss sichergestellt sein, dass die Einspeisung oder die Auswirkung von weiteren Teilen des Netzes über die Messpunkte erfassbar sind. Im Fall der beispielhaften Netz in Figuren 1 und 2 müssen für die Fehlerortung folgende Merkmale erkannt werden:

a) Strahlennetz

- beidseitige Einspeisung; oder
- einseitige Einspeisung und vorgeschaltete Abzweige bzw. Löschspulen auf der anderer Seite.

b) Ringnetz

- Ring ist nicht offen, d.h. die Einspeisung kommt von beiden Seiten; oder
- Ring ist offen, d.h. eine einseitige Einspeisung von einem Ringende und die vorgeschalteten Abzweige bzw. Löschspulen auf dem anderem Ringende.

Wenn die Bedingungen von a) bzw. b) nicht erfüllt sind, kann man die Fehlerortung mit Spannungsgrößen durchgeführt werden. Erfahrungsgemäß finden sich auf der Mittelspannungsebene primäre Spannungswandler, die ein breitbandiges Übertragungsverhalten aufweisen und zur Fehlererfassung und -ortung mit Wanderwellen geeignet sind.

Abschließend soll zur besseren Veranschaulichung der Vorgehensweise bei der Fehlerortung ein konkretes Beispiel basierend auf dem Strahlennetz gemäß Figur 9 erläutert werden.

Das beispielhafte Verteilnetz wird von einer Seite gespeist. Als Messort wird Messstelle A auf dem Hauptstrang hinter dem ersten Abgang (von der Einspeisung aus gesehen) gewählt. Falls sich an der Sammelschiene am Messort A weitere Abgänge befinden, können diese zu einer Gesamtlänge $\sum_{k=1}^{K} l_k$ zusammengefast werden. Diese Gesamtlänge wird als Kriterium zur Auswahl der zur Fehlerortung benutzten Messgrößen benötigt. Für Stromsignale ist eine Mindestlänge erforderlich. Spannungsgrößen können hingegen ohne Einschränkungen immer benutzt werden, sofern entsprechende Wandler vorhanden sind.

Messstelle B wird auf dem Hauptstrang vor dem letzten Abgang gewählt. Von dieser Seite wird das Versorgungsnetz nicht gespeist, besitzt aber weitere Abzweige. Somit ist die oben unter a) beschriebene Bedingung für die Fehlerortung erfüllt. Zur Beschreibung der Segmente des Hauptstrangs zwischen Messstellen A und B sowie der Abzweige werden folgende Mengen aufgestellt:

$$d = \{5\text{km}, \ 3\text{km}, 2\text{km}, 10\text{km}\},$$

$$l = \{8\text{km}, \ 2\text{km}, 3\text{km}\}$$

Der im Beispiel angenommene Fehler liegt als Erdschluss auf dem zweiten Abzweig auf einer Position von $\Delta x$ = 3,5 km (Abstand vom Ort des Abzweigs vom Hauptstrang). Die modalen Wellenausbreitungsgeschwindigkeiten für das Verteilnetz seien bei

$$v_0 = 196910 \ \text{km/s},$$

$$v_{\alpha,\beta} = 294290 \ \text{km/s}$$

angenommen. Es handele sich um ein homogenes Netzgebilde, so dass die Parameter aller Segmente gleich sind.

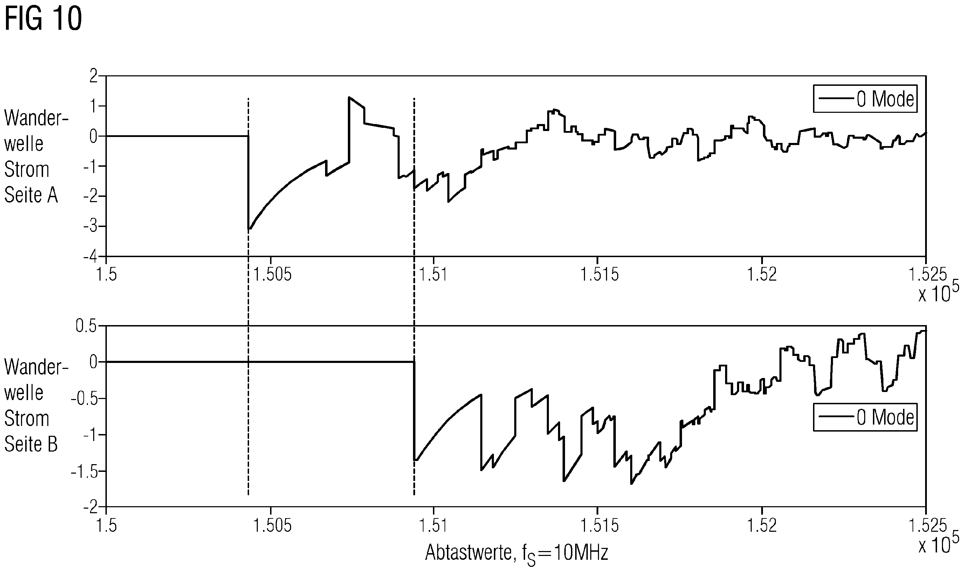

Es wird der Fehlerort als Entfernung von der Messstelle A gesucht. Das erwartete Ergebnis beträgt 8,5km (vgl. Figur 9). Zur Ermittlung des Erdschlusses werden Stromsignale betrachtet, um das Eintreffen von durch den Fehler hervorgerufenen Wanderwellen an den Messstellen A und B zu detektieren. Beispielhaft sind die Verläufe der modalen Nullkomponenten an beiden Messstellen in den Diagrammen der Figur 10 dargestellt.

Im Rahmen einer zweiseitigen Fehlerortung werden die Zeitpunkte des Eintreffens der Wanderwellen an den beiden Messstellen festgehalten. Die Zeitpunkte werden in die oben genannte Gleichung für die zweiseitige Fehlerortung eingesetzt:

$$x = \frac{L + \left(t_{A(0)} - t_{B(0)}\right) \cdot v_0}{2}$$

$$x = \frac{20km + (15043{,}5\,\mu s - 15094{,}3\,\mu s) \cdot 196910km/s}{2} = 5km$$

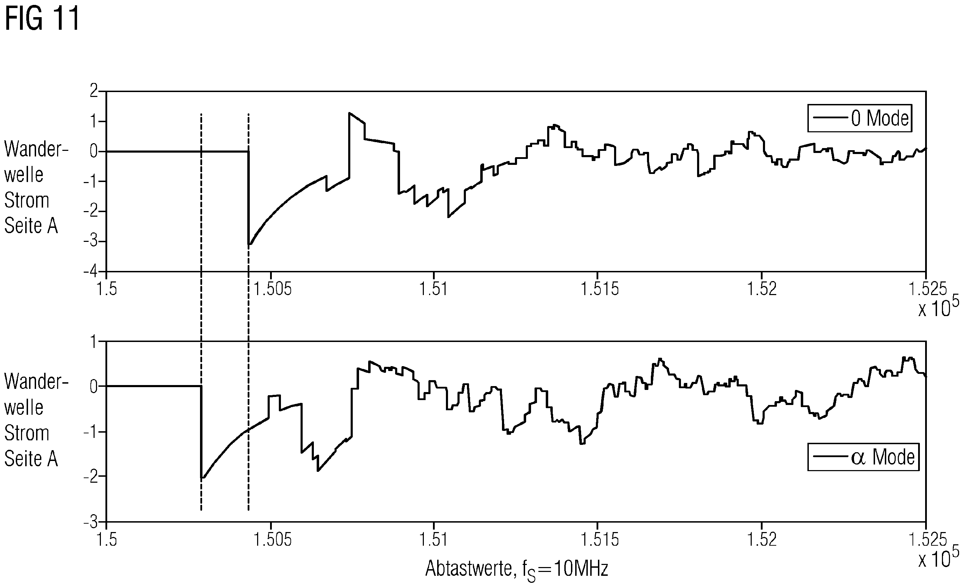

Da der berechnete erste Fehlerortwert auf die Distanz auf dem Hauptstrang bis zum ersten Abzweig hinweist

$$x = 5km \in \{5km, 3km, 2km, 10km\}$$

kann der Fehler entweder direkt am Ort des Abzweigs auf dem Hauptstrang oder auf dem Abzweig selbst liegen. Zur genaueren Ortung wird die einseitige Fehlerortung unter Verwendung der modalen Nullkomponente und der modalen $\alpha$- oder $\beta$-Komponente durchgeführt. Bei der einseitige Fehlerortung wird quasi die Entfernung von der Messstelle A als zweiter Fehlerortwert bestimmt. Bei Kenntnis des ersten Fehlerortwerts kann bei nicht identischen Fehlerortwerten daraufhin die Entfernung auf dem fehlerbehafteten Abzweig bestimmt werden. Dafür wird die oben genannte Gleichung verwendet, die einzusetzenden Zeitpunkte ergeben sich aus den Diagrammen in Figur 11:

$$\Delta x = \frac{\Delta t_{A(\alpha,\beta,0)} - d_{Abzweig(i)} \cdot k_{v\_Hauptstrang}}{k_{v\_Abzweig(i)}}$$

$$\Delta x = \frac{(15029{,}2\mu s - 15043{,}5\mu s) - 5km \cdot (-1{,}6805 . \frac{10^{-6}s}{km})}{(-1{,}6805 . \frac{10^{-6}s}{km})} = 3{,}509km$$

Insgesamt ergibt sich damit ein tatsächlicher Fehlerort von 8,509km als Entfernung von der Messstelle A.

Die beschriebene Vorgehensweise liefert eine Lösung zur wirtschaftlichen und effizienten Fehlerlokalisierung, insbesondere in doppelt oder einfach gespeisten, nicht wirksam geerdeten Mittelspannungs-Verteilnetzen, bei der nur Daten von zwei Messstellen erforderlich sind. Je nach Topologie der Netze kann allein mit Stromsignalen gearbeitet werden, so dass häufig keine zusätzlichen Spannungswandler installiert werden müssen. Damit ermöglicht die Vorgehensweise eine kosteneffiziente Fehlerortbestimmung in nicht wirksam geerdeten Netzen mit einem Mindestmaß an erforderlicher Gerätetechnik und kann so den erforderlichen Aufwand zur Fehlerortung gegenüber herkömmlichen Lösungen deutlich senken. Das ermöglicht eine Fehlerortung in Netzen, in denen bisher eine wirtschaftliche Lösung nicht möglich war. Bei Vorhandensein von Spannungswandlern können die Messstellen auch direkt am Anfang und Ende des Hauptstrangs gewählt werden.

Bei der beschriebenen Vorgehensweise wird vorzugsweise jeweils eine Messstelle hinter dem ersten Abgang und vor dem letzten Abgang (von der Haupteinspeisung aus gesehen) angeordnet. An den Messstellen werden die jeweiligen Zeitpunkte des Eintreffens von Wanderwellen erfasst und in einer Einrichtung zur Fehlerortung ausgewertet. Dies kann eine zentrale Einrichtung sein. Es können aber auch eine oder zwei dezentrale Einrichtungen verwendet werden, in die vorzugsweise die Messeinrichtungen zur Erfassung der Strom- bzw. Spannungssignale integriert sind. Es werden unterschiedliche modale Komponenten der Wanderwelle betrachtet und durch Kombination der Ergebnisse einer zweiseitigen und einer einseitigen Fehlerortung wird der Fehlerort bestimmt. Bei Übereinstimmung der Ergebnisse der zweiseitigen und der einseitigen Fehlerortung wird der berechnete Fehlerort auf dem Hauptstrang als tatsächlicher Fehlerort ausgegeben. Bei Nicht-Übereinstimmung beider Fehlerortungsergebnisse wird die Differenz beider Fehlerentfernungen als Fehlerentfernung angegeben. Der fehlerbehaftete Abzweig wird durch das Ergebnis der zweiseitigen Fehlerortung bestimmt.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Ermitteln eines Fehlerortes in einem elektrischen Energieverteilnetz (10,20), wobei das Energieverteilnetz (10, 20) zumindest eine Einspeisung sowie Leitungen in Form eines Hauptstrangs (11) und einer Mehrzahl von vom Hauptstrang (11) abgehenden Abzweigen (12) aufweist, und wobei bei dem Verfahren

   - an einer ersten Messstelle (13a) des Energieverteilnetzes (10, 20) erste Messwerte erfasst werden;
   - an einer zweiten Messstelle (13b) des Energieverteilnetzes (10,20) zweite Messwerte erfasst werden; und
   - anhand der ersten und der zweiten Messwerte der Fehlerort des im Energieverteilnetz (10,20) aufgetretenen Fehlers ermittelt wird;

   **dadurch gekennzeichnet, dass**

   - anhand der ersten und der zweiten Messwerte das Eintreffen von jeweiligen Wanderwellen erkannt wird, die auf einen im Energieverteilnetz (10,20) aufgetretenen Fehler hinweisen, und die Zeitpunkte des jeweiligen Eintreffens der Wanderwelle gespeichert werden;
   - mittels der jeweiligen Zeitpunkte von beiden Messstellen eine erste Fehlerortung unter Erzeugung eines ersten Fehlerortwertes durchgeführt wird;
   - mittels der Zeitpunkte nur der ersten Messstelle eine zweite Fehlerortung unter Erzeugung eines zweiten Fehlerortwertes durchgeführt wird; und
   - der Fehlerort basierend auf dem ersten Fehlerortwert und dem zweiten Fehlerortwert ermittelt wird, so dass eine zweiseitige Fehlerortung mit einer einseitigen Fehlerortung kombiniert wird.

2. Verfahren nach Anspruch 1,
   **dadurch gekennzeichnet, dass**

   - die erfassten Messwerte in modale Komponenten zerlegt werden, wobei zumindest zwei der Komponenten unterschiedliche Ausbreitungsgeschwindigkeiten entlang der Leitungen des Energieverteilnetzes (10, 20) aufweisen; und
   - für die erste und die zweite Fehlerortung zumindest teilweise unterschiedliche modale Komponenten herangezogen werden.

3. Verfahren nach Anspruch 2,
   **dadurch gekennzeichnet, dass**

   - für die erste Fehlerortung zur Bildung des ersten Fehlerortwertes jeweilige Zeitpunkte verwendet werden, zu denen die jeweils erste Wellenflanke einer modalen Null-Komponente der jeweiligen Wanderwelle an der ersten und der zweiten Messstelle (13a, 13b) eingetroffen ist.

4. Verfahren nach Anspruch 2 oder 3,
   **dadurch gekennzeichnet, dass**

   - für die zweite Fehlerortung zur Bildung des zweiten Fehlerortwertes jeweilige Zeitpunkte verwendet werden, zu denen die jeweils erste Wellenflanke einer modalen Null-Komponente und einer modalen $\alpha$- oder $\beta$-Komponente der Wanderwelle an der ersten Messstelle (13a) eingetroffen ist.

5. Verfahren nach einem der vorangehenden Ansprüche,
   **dadurch gekennzeichnet, dass**

   - für den Fall, dass der erste Fehlerortwert und der zweite Fehlerortwert übereinstimmen, der entsprechende Ort auf dem Hauptstrang (11) als Fehlerort bestimmt wird.

6. Verfahren nach einem der vorangehenden Ansprüche,
   **dadurch gekennzeichnet, dass**

   - für den Fall, dass der erste Fehlerortwert vom zweiten Fehlerortwert abweicht, der Fehlerort als auf einem der Abzweige (12) liegend erkannt wird.

**7.** Verfahren nach Anspruch 6,
**dadurch gekennzeichnet, dass**

- der fehlerbehaftete Abzweig (12), auf dem der Fehlerort liegt, durch den ersten Fehlerortwert angegeben wird.

**8.** Verfahren nach Anspruch 7,
**dadurch gekennzeichnet, dass**

- der konkrete Fehlerort auf dem fehlerbehafteten Abzweig (12) als Differenz aus dem zweiten Fehlerortwert und dem ersten Fehlerortwert bestimmt wird.

**9.** Verfahren nach einem der vorangehenden Ansprüche,
**dadurch gekennzeichnet, dass**

- als Messwerte hochfrequente Strom- und/oder Spannungsmesswerte an der jeweiligen Messstelle (13a, 13b) verwendet werden.

**10.** Verfahren nach einem der vorangehenden Ansprüche,
**dadurch gekennzeichnet, dass**

- die Messwerte in einem Ringpuffer abgespeichert werden, dessen Inhalt festgeschrieben wird, sobald im Verlauf zumindest eines der Messwerte eine Wanderwelle erkannt worden ist.

**11.** Einrichtung (14a, 14b, 22) zum Ermitteln eines Fehlerortes in einem elektrischen Energieverteilnetz (10,20), wobei das Energieverteilnetz (10, 20) zumindest eine Einspeisung sowie Leitungen in Form eines Hauptstrangs (11) und einer Mehrzahl von vom Hauptstrang (11) abgehenden Abzweigen (12) aufweist, wobei

- die Einrichtung (14a, 14b, 22) eine Auswerteinrichtung (16a, 16b, 24) aufweist, die dazu eingerichtet ist, anhand von Zeitpunkten, zu denen jeweilige Wanderwellen an einer ersten und einer zweiten Messstelle (13a, 13b) des Energieverteilnetzes (10, 20) eingetroffen sind, den Fehlerort eines im Energieverteilnetz (10, 20) aufgetretenen Fehlers zu ermitteln;
**dadurch gekennzeichnet, dass**
- die Auswerteinrichtung (16a, 16b, 24) dazu eingerichtet ist, mittels der jeweiligen Zeitpunkte von beiden Messstellen (13a, 13b) eine erste Fehlerortung unter Erzeugung eines ersten Fehlerortwertes durchzuführen;
- die Auswerteinrichtung (16a, 16b, 24) dazu eingerichtet ist, mittels der Zeitpunkte nur der ersten Messstelle (13a) eine zweite Fehlerortung unter Erzeugung eines zweiten Fehlerortwertes durchzuführen; und
- die Auswerteinrichtung (16a, 16b, 24) dazu eingerichtet ist, den Fehlerort basierend auf dem ersten Fehlerortwert und dem zweiten Fehlerortwert zu ermitteln, so dass eine zweiseitige Fehlerortung mit einer einseitigen Fehlerortung kombiniert wird.

**12.** Einrichtung (22) nach Anspruch 11,
**dadurch gekennzeichnet, dass**

- die Einrichtung (22) eine zentrale Datenverarbeitungseinrichtung ist, die eine Kommunikationseinheit (25) aufweist, die zum Empfang von Informationen eingerichtet ist, die die Zeitpunkte des Eintreffens der Wanderwellen an der ersten und der zweiten Messstelle (13a, 13b) angeben.

**13.** Einrichtung (22) nach Anspruch 12,
**dadurch gekennzeichnet, dass**

- die Einrichtung (22) eine Cloud-Datenverarbeitungseinrichtung ist.

**14.** Einrichtung (14a, 14b) nach Anspruch 11,
**dadurch gekennzeichnet, dass**

- die Einrichtung eine interne Messeinrichtung (17a, 17b) umfasst, die dazu eingerichtet ist, erste Messwerte an der ersten Messstelle (13a) des Energieverteilnetzes (10, 20) zu erfassen und den jeweiligen Zeitpunkt des Eintreffens einer Wanderwelle zu bestimmen; und

- die Einrichtung ein Kommunikationsmodul (18a, 18b) aufweist, das dazu eingerichtet ist, eine Information über den jeweiligen Zeitpunkt des Eintreffens einer Wanderwelle an der zweiten Messstelle (13b) von einer entfernt angeordneten Messeinrichtung (17a, 17b) zu empfangen.

**Claims**

1. Method for determining a fault location in an electric power distribution network (10, 20), wherein the power distribution network (10, 20) comprises at least one infeed as well as lines in the form of a main strand (11) and a multiplicity of branches (12) branching off from the main strand (11), and wherein, in the method,

   - first measured values are acquired at a first measurement point (13a) of the power distribution network (10, 20);
   - second measured values are acquired at a second measurement point (13b) of the power distribution network (10, 20); and
   - the fault location of the fault that has occurred in the power distribution network (10, 20) is determined on the basis of the first and the second measured values;

   **characterized in that**

   - the arrival of respective travelling waves is identified on the basis of the first and the second measured values, these travelling waves indicating a fault that has occurred in the power distribution network (10, 20), and the times of the respective arrival of the travelling wave are stored;
   - a first fault location is performed using the respective times of both measurement points, generating a first fault location value in the process;
   - a second fault location is performed using the times of only the first measurement point, generating a second fault location value in the process; and
   - the fault location is determined based on the first fault location value and the second fault location value, such that bilateral fault location is combined with unilateral fault location.

2. Method according to Claim 1,
   **characterized in that**

   - the acquired measured values are broken down into modal components, wherein at least two of the components have different propagation speeds along the lines of the power distribution network (10, 20); and
   - at least partially different modal components are applied for the first and the second fault location.

3. Method according to Claim 2,
   **characterized in that**

   - respective times are used for the first fault location for forming the first fault location value, at which times the in each case first wave edge of a modal zero component of the respective travelling wave arrived at the first and the second measurement point (13a, 13b).

4. Method according to Claim 2 or 3,
   **characterized in that**

   - respective times are used for the second fault location for forming the second fault location value, at which times the in each case first wave edge of a modal zero component and of a modal $\alpha$ or $\beta$ component of the travelling wave arrived at the first measurement point (13a).

5. Method according to one of the preceding claims,
   **characterized in that**

   - in the event that the first fault location value and the second fault location value match, the corresponding location on the main strand (11) is ascertained as fault location.

6. Method according to one of the preceding claims,
   **characterized in that**

- in the event that the first fault location value differs from the second fault location value, the fault location is identified as being located on one of the branches (12).

7. Method according to Claim 6,
   **characterized in that**

   - the faulty branch (12) on which the fault location is located is indicated by the first fault location value.

8. Method according to Claim 7,
   **characterized in that**

   - the specific fault location on the faulty branch (12) is ascertained as the difference between the second fault location value and the first fault location value.

9. Method according to one of the preceding claims,
   **characterized in that**

   - high-frequency current and/or voltage measured values at the respective measurement point (13a, 13b) are used as measured values.

10. Method according to one of the preceding claims,
    **characterized in that**

    - the measured values are stored in a ring buffer, the content of which is frozen as soon as a travelling wave has been identified in the course of at least one of the measured values.

11. Device (14a, 14b, 22) for determining a fault location in an electric power distribution network (10, 20), wherein the power distribution network (10, 20) has at least one infeed as well as lines in the form of a main strand (11) and a multiplicity of branches (12) branching off from the main strand (11), wherein

    - the device (14a, 14b, 22) has an evaluation device (16a, 16b, 24) that is designed to determine the fault location of a fault that has occurred in the power distribution network (10, 20) on the basis of times at which respective travelling waves arrived at a first and a second measurement point (13a, 13b) of the power distribution network (10, 20);

    **characterized in that**

    - the evaluation device (16a, 16b, 24) is designed to perform a first fault location using the respective times of both measurement points (13a, 13b), generating a first fault location value in the process;
    - the evaluation device (16a, 16b, 24) is designed to perform a second fault location using the times of only the first measurement point (13a), generating a second fault location value in the process; and
    - the evaluation device (16a, 16b, 24) is designed to determine the fault location based on the first fault location value and the second fault location value, such that bilateral fault location is combined with unilateral fault location.

12. Device (22) according to Claim 11,
    **characterized in that**

    - the device (22) is a central data processing device that has a communication unit (25) that is designed to receive information that indicates the times of arrival of the travelling waves at the first and the second measurement point (13a, 13b).

13. Device (22) according to Claim 12,
    **characterized in that**

    - the device (22) is a cloud data processing device.

14. Device (14a, 14b) according to Claim 11,
    **characterized in that**

- the device comprises an internal measuring device (17a, 17b) that is designed to acquire first measured values at the first measurement point (13a) of the power distribution network (10, 20) and to ascertain the respective time of arrival of a travelling wave; and
- the device has a communication module (18a, 18b) that is designed to receive information about the respective time of arrival of a travelling wave at the second measurement point (13b) from a remotely arranged measuring device (17a, 17b).

**Revendications**

1. Procédé de détermination d'un emplacement défectueux dans un réseau (10, 20) de distribution d'énergie électrique, dans lequel le réseau (10, 20) de distribution d'énergie a au moins une alimentation ainsi que des lignes sous la forme d'une branche (11) principale et d'une pluralité de dérivations (12) partant de la branche (11) principale, et dans lequel dans le procédé

- on détecte des premières valeurs de mesure en un premier point (13a) de mesure du réseau (10, 20) de distribution d'énergie ;
- on détecte des deuxièmes valeurs de mesure en un deuxième point (13b) de mesure du réseau (10, 20) de distribution d'énergie ; et
- à l'aide des premières et deuxièmes valeurs de mesure, on détermine l'emplacement du défaut, qui s'est produit dans le réseau (10, 20) de distribution d'énergie ;

**caractérisé en ce que**

- à l'aide des premières et des deuxièmes valeurs de mesure, on détecte l'arrivée d'ondes progressives respectives, qui indiquent des défauts, qui se sont produits dans le réseau (10, 20) de distribution d'énergie, et on met en mémoire les instants de l'arrivée respective de l'onde progressive ;
- au moyen des instants respectifs des deux points de mesure, on effectue une première localisation de défaut en produisant une première valeur d'emplacement défectueux ;
- au moyen des instants seulement du premier point de mesure, on effectue une deuxième localisation de défaut en produisant une deuxième valeur d'emplacement défectueux ; et
- on détermine l'emplacement défectueux sur la base de la première valeur d'emplacement défectueux et de la deuxième valeur d'emplacement défectueux, de manière à combiner une localisation de défaut de deux côtés à une localisation de défaut d'un côté.

2. Procédé suivant la revendication 1,
   **caractérisé en ce que**

   - l'on décompose les valeurs de mesure détectées en des composantes modales, dans lequel au moins deux des composantes ont des vitesses de propagation différentes sur les lignes du réseau (10, 20) de distribution d'énergie ; et
   - l'on tire parti au moins en partie de composantes modales différentes pour la première et la deuxième localisations de défaut.

3. Procédé suivant la revendication 2,
   **caractérisé en ce que**

   - l'on utilise, pour la première localisation de défaut pour la formation de la première valeur d'emplacement défectueux respectivement, des instants où les premiers fronts respectifs d'onde d'une première composante modale nulle de l'onde progressive respective est arrivée au premier et au deuxième points (13a, 13b) de mesure.

4. Procédé suivant la revendication 2 ou 3,
   **caractérisé en ce que**

   - l'on utilise, pour la deuxième localisation de défaut pour la formation de la deuxième valeur d'emplacement défectueux, respectivement des instants où les premiers fronts respectifs d'une composante modale nulle et d'une composante modale a ou β est arrivée au premier point (13a) de mesure.

**5.** Procédé suivant l'une des revendications précédentes,
**caractérisé en ce que**

- pour le cas où la première valeur d'emplacement défectueux et la deuxième valeur d'emplacement défectueux coïncident, on détermine l'emplacement correspondant sur la branche (11) principale comme emplacement du défaut.

**6.** Procédé suivant l'une des revendications précédentes,
**caractérisé en ce que**

- dans le cas où la première valeur d'emplacement défectueux se distingue de la deuxième valeur d'emplacement défectueux, on détecte que l'emplacement défectueux est sur l'une des dérivations (12) .

**7.** Procédé suivant la revendication 6,
**caractérisé en ce que**

- l'on indique la dérivation (12) entachée d'un défaut, sur laquelle il y a l'emplacement défectueux, par la première valeur d'emplacement défectueux.

**8.** Procédé suivant la revendication 7,
**caractérisé en ce que**

- l'on détermine l'emplacement concret du défaut sur la branche (12) entachée du défaut comme différence à partir de la deuxième valeur d'emplacement défectueux et la première valeur d'emplacement défectueux.

**9.** Procédé suivant l'une des revendications précédentes,
**caractérisé en ce que**

- l'on utilise comme valeurs de mesure des valeurs de mesure de courant et/ou de tension en haute fréquence aux points (13a, 13b) de mesure respectifs.

**10.** Procédé suivant l'une des revendications précédentes,
**caractérisé en ce que**

- l'on mémorise les valeurs de mesure dans un tampon annulaire, dont on enregistre le contenu, dès qu'une onde progressive a été détectée dans la courbe d'au moins l'une des valeurs de mesure.

**11.** Dispositif (14a, 14b, 22) de détermination d'un emplacement défectueux dans un réseau (10, 20) de distribution, dans lequel le réseau (10, 20) de distribution d'énergie a au moins une alimentation ainsi que des lignes sous la forme d'une branche (11) principale et d'une pluralité de dérivations (12) partant de la branche (11) principale, dans lequel

- le dispositif (14a, 14b, 22) a un dispositif (16a, 16b, 24) d'analyse, qui est agencé pour, à l'aide des instants où des ondes progressives respectives sont arrivées à un premier point (13a, 13b) de meure du réseau (10, 20) de distribution d'énergie, déterminer l'emplacement défectueux d'un défaut, qui s'est produit dans le réseau (10, 20) de distribution d'énergie ;

**caractérisé en ce que**

- le dispositif (16a, 16b, 24) d'analyse est agencé pour effectuer, en produisant une première valeur d'emplacement défectueux, une première localisation du défaut, au moyen des instants respectifs des deux points (13a, 13b) de mesure ;
- le dispositif (16a, 16b, 24) d'analyse est agencé pour, au moyen des instants de seulement le premier point (13a) de mesure, n'effectuer qu'une deuxième localisation du défaut avec production d'une deuxième valeur d'emplacement défectueux ; et
- le dispositif (16a, 16b, 24) d'analyse est agencé pour déterminer l'emplacement défectueux, sur la base de la première valeur d'emplacement défectueux et de la deuxième valeur d'emplacement défectueux, de manière à combiner une localisation du défaut de deux côtés avec une localisation du défaut d'un côté.

**12.** Dispositif (22) suivant la revendication 11,
**caractérisé en ce que**

- le dispositif (22) est un dispositif central de traitement de données, qui a une unité (25) de communication agencée pour la réception d'informations, qui indiquent les instants de l'arrivée des ondes progressives au premier et au deuxième points (13a, 13b) de mesure.

**13.** Dispositif (22) suivant la revendication 12,
**caractérisé en ce que**

- le dispositif (22) est un dispositif de traitement de données à nuage.

**14.** Dispositif (14a, 14b) suivant la revendication 11,
**caractérisé en ce que**

- le dispositif comprend un dispositif (17a, 17b) interne de mesure, qui est agencé pour détecter des premières valeurs de mesure au premier point (13a) de mesure du réseau (10, 20) de distribution d'énergie et pour déterminer l'instant respectif de l'arrivée d'une onde progressive ; et
- le dispositif a un module (18a, 18b) de communication, qui est agencé pour recevoir une information sur l'instant respectif de l'arrivée d'une onde progressive au deuxième point (13b) de mesure d'un dispositif (17a, 17b) de mesure disposé à distance.

FIG 1

FIG 2

EP 3 968 037 B1

FIG 3

FIG 4

FIG 5

FIG 6

FIG 7

14a

12b

14b

11

$t_{A(0)}$

$t_0$

$t_A$

$t_{BN(0)}$

$t_B$

FIG 8

14a

12b

14b

11

$t_{A(\alpha,\beta)}$

$t_{0(0)}$

$t_{A(0)}$

$t_A$

FIG 9

$d_1=5km$   $d_2=3km$   $d_3=2km$   $d_4=10km$

A

$\Delta x=3,5km$

B

$\Sigma I_k$

$I_1=8km$   $I_2=2km$   $I_3=2km$

$\Sigma I_m$

FIG 10

Wanderwelle
Strom
Seite A

Wanderwelle
Strom
Seite B

Abtastwerte, $f_S = 10\text{MHz}$

EP 3 968 037 B1

FIG 11

Wanderwelle
Strom
Seite A

Wanderwelle
Strom
Seite A

Abtastwerte, $f_S = 10\text{MHz}$

EP 3 968 037 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4996624 A
- US 5929642 A
- US 9279846 B2
- US 8655609 B2

**In der Beschreibung aufgeführte Nicht-Patentliteratur**

- Electric Transmission Fault Location Techniques Using Traveling Wave Method and Discrete Wavelet Transform. **FLUTY WESLEY et al.** CLEMSON UNIVERSITY POWER SYSTEMS CONFERENCE (PSC). IEEE, 10. Marz 2020, 1-8